**Europäisches Patentamt**

**European Patent Office**

**Office européen des brevets**

(19)

(11) Veröffentlichungsnummer : **0 169 265**
**B1**

(12) # EUROPÄISCHE PATENTSCHRIFT

(45) Veröffentlichungstag der Patentschrift :
**09.11.88**

(51) Int. Cl.⁴ : **H 05 K   3/42**

(21) Anmeldenummer : **84109587.0**

(22) Anmeldetag : **11.08.84**

(54) **Verfahren zur Herstellung von Durchkontaktierungen in gedruckten Schaltungen.**

(30) Priorität : **21.07.84 DE 3427015**

(43) Veröffentlichungstag der Anmeldung :
**29.01.86 Patentblatt 86/05**

(45) Bekanntmachung des Hinweises auf die Patenterteilung : **09.11.88 Patentblatt 88/45**

(84) Benannte Vertragsstaaten :
**DE FR GB NL**

(56) Entgegenhaltungen :
**EP-A- 0 071 375**
**WO-A-79 /000 83**
**GB-A-   854 881**

(73) Patentinhaber : **NIPPON MEKTRON, LTD.**
**12-15, 1-Chome Shiba Daimon**
**Minato-ku Tokyo (JP)**

(72) Erfinder : **Matsumoto, Hirofumi**
**2733-76 Okami Ushiku-Cho**
**Inashiki-Gun Ibaraki-Ken, 300-12 (JP)**

(74) Vertreter : **Weissenfeld-Richters, Helga, Dr.**
**Höhnerweg 2**
**D-6940 Weinheim/Bergstrasse (DE)**

## Beschreibung

Die Erfindung betrifft ein Verfahren zur Herstellung von Durchkontaktierungen in einem Verbund aus einer flexiblen mit einer starren gedruckten Schaltung.

In der Leiterplatten-Elektronik ist es oftmals erforderlich, eine flexible mit einer starren gedruckten Schaltung über Bohrungen, welche an ihrer Innenseite plattiert sind, elektrisch zu verbinden. Während des Plattiervorganges zum Zwecke des Durchkontaktierens erleiden die Leiterbahnen der flexiblen Komponente häufig Beschädigungen im Anschlußbereich um die Bohrungen. Als Gegenmaßnahme ist es möglich, die Flächen im Anschlußbereich während dieses Vorganges mit einem leicht wieder entfernbaren Belag zu versehen. Jedoch können bei diesen Manipulationen die Leiterbahnen leicht in Mitleidenschaft gezogen werden, wenn das Abziehen nicht mit höchster Sorgfalt geschieht.

Die DE-OS 25 24 581 zeigt weitere Schwierigkeiten auf, allerdings bezogen auf Stapel von beidseitig mit Leiterbahnen versehenen, flexiblen gedruckten Schaltungen :

Das gezielte Metallisieren der Bohrungswandungen ist aufwendig und teuer, und die Flexibilität der Leiterplatten erleidet im Umfeld der Bohrungen (Anschlußbereich) infolge des Niederschlages von Plattiermaterial erhebliche Einbußen.

Als Abhilfe schlägt die genannte Anmeldung vor, die Löcher mit einem Spezialwerkzeug so zu stanzen, daß ein Lappen aus Kernmaterial in der Bohrung verbleibt und in ausreichendem Maße von flüssigem Lot benetzt werden kann. Diese Maßnahme ist jedoch aus mechanischen Gründen nicht ohne weiteres auf den hier zur Debatte stehenden Verbund einer flexiblen mit einer starren Leiterplatte übertragbar.

Die Aufgabe der vorliegenden Erfindung besteht nunmehr darin, ein Verfahren aufzuzeigen, mit dem Durchkontaktierungsbohrungen für die elektrische Verbindung einer flexiblen mit einer starren, darunter befestigten Schaltung ohne größeren Aufwand und kostengünstig plattiert werden können, ohne daß die Gefahr einer Beschädigung von Leiterbahnen im Anschlußbereich der obenliegenden, flexiblen Platte besteht. Ferner soll deren Biegsamkeit dabei nicht beeinträchtigt werden.

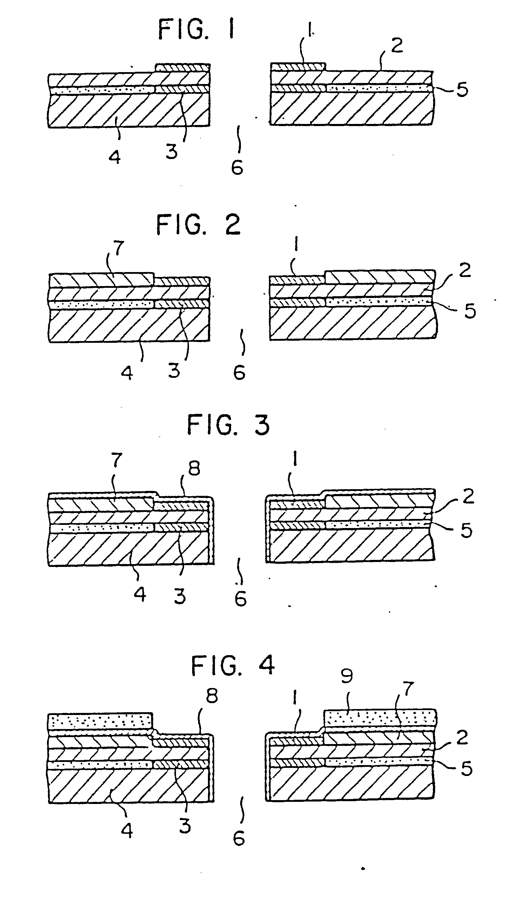

Diese Aufgabe wird durch die erfindungsgemäße Kombination der im Patentanspruch 1 angegebenen Verfahrensschritte gelöst. Zu deren näheren Erläuterung dienen die Figuren 1-7, welche jeweils im Querschnitt die zeitlich aufeinanderfolgenden Fertigungszustände einer beispielhaften Ausführung des Schaltungsverbundes darstellen.

Figur 1 zeigt eine flexible (2) auf einer starren (4) gedruckten Schaltung bzw. Leiterplatte wobei eine geeignete Kleberschicht 5 deren feste Verbindung miteinander bewirkt. Die durchgehende Bohrung 6 liegt innerhalb der jeweiligen Anschlußbereiche 1 und 3.

Wie aus Figur 2 ersichtlich, wird im zweiten erfindungsgemäßen Verfahrensschritt die Oberfläche der flexiblen Platte 2, mit Ausnahme des Anschlußbereichs 1, mit einem an sich bekannten, leicht wieder abziehbaren Maskierungsband 7 versehen. Dieses besteht beispielsweise aus PVC.

Figur 3 zeigt den Zustand des Schaltungsverbundes nach der Durchführung des dritten erfindungsgemäßen Verfahrensschrittes ; in ihm werden alle zugänglichen Oberflächen einschließlich der Maske 7 sowie die Innenwandung der Bohrung 6 mit einer Schicht 8 stromlos plattiert. Diese besteht vorzugsweise aus chemisch abgeschiedenen Kupfer.

Der folgende Verfahrensschritt besteht im Auftragen einer Photoresist-Schicht 9 auf das mit der Plattierschicht 8 bedeckte Band 7. Die Bohrung 6 und der Anschlußbereich 1 werden dabei ausgespart, so daß eine Konstellation gemäß Figur 4 entsteht.

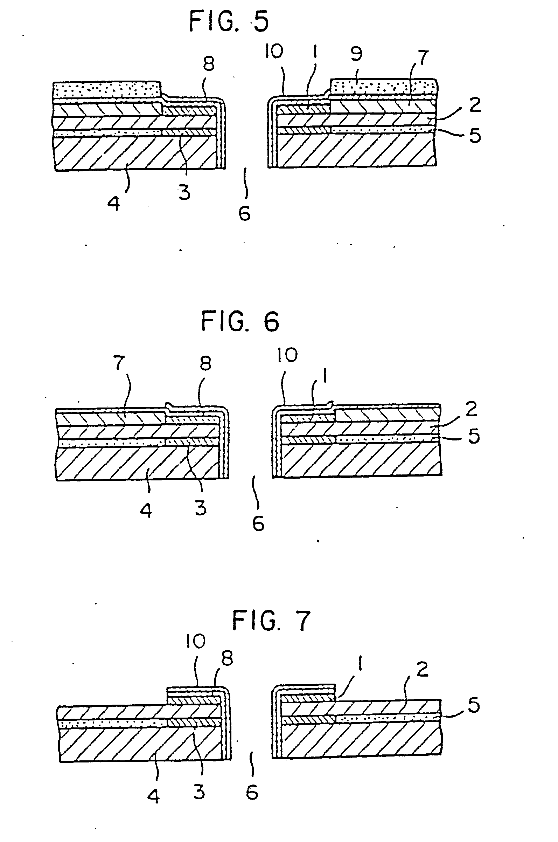

Im fünften Verfahrensschritt werden die Innenwandung der Bohrung 6 sowie der mit der Schicht 8 bereits bedeckte Anschlußbereich 1 gleichmäßig elektrolytisch mit einer Schicht 10 plattiert. Wie dabei aus Figur 5 hervorgeht, ist hiermit die elektrische Verbindung zwischen den Anschlußbereichen 1 und 3 der beiden Schaltungen 2 und 4 hergestellt.

Die letzten beiden Maßnahmen der vorliegenden Erfindung bestehen im Entfernen des Photoresists 9 mit Hilfe einer Lösungsflüssigkeit (peeling fluid) und im darauffolgenden Abziehen das Maskierungsbandes 7 mit dem darauf befindlichen Abschnitt der nicht mehr benötigten Plattierung 8. Figur 6 und 7 zeigen hierzu die jeweiligen Zustände des Leiterplattensystems ; Figur 7 stellt im Querschnitt somit die erfindungsgemäß fertiggestellte Durchkontaktierung eines Verbundes flexible (2)/starre (4) gedruckte Schaltung dar.

Das erfindungsgemäße Verfahren erlaubt die sichere Durchkontaktierung der Anschlußbereiche ohne ein Zerstörungsrisiko für die flexible Komponente. Da die Photoresist-Schicht 9 auf der Maskierung 7 nicht direkt aufliegt, sondern die stromlos aufgegetragene Plattierung 8 sich dazwischen befindet, besteht beim Abtrennen keine Gefahr einer Beschädigung der flexiblen Schaltung, da ja die Plattierung 8 in diesem Bereich ohnehin ebenfalls wieder entfernt werden muß.

Bei Anwendung des erfindungsgemäßen Verfahrens ist somit eine rasche, kostengünstige und beschädigungsfreie Herstellung von Durchkontaktierungen durch den erwähnten Schaltungsverbund möglich, wobei auch die Flexibilität der oberen Platte 2 nicht beeinträchtigt wird.

Bezugszeichenliste

1, 3 Anschlußbereiche der Leiterbahnen auf den Leiterplatten 2 und 4

2 Flexible gedruckte Schaltung
4 Starre gedruckte Schaltung
5 Kleberschicht
6 Durchgehende Bohrung
7 Maskierungsband
8 stromlos aufgetragene Plattierschicht
9 Photoresist-Schicht
10 elektrolytisch aufgetragene Plattierschicht

**Patentansprüche**

1. Verfahren zur Herstellung von Durchkontaktierungen (6) in einem Verbund, bestehend aus einer flexiblen (2) und einer starren (4) gedruckten Schaltung, das die Kombination folgender Verfahrensschritte aufweist :

a) Herstellen durchgehender Bohrungen (6) innerhalb von jeweiligen Anschlußbereichen (1, 3) der flexiblen (2) und der starren (4) gedruckten Leiterplatte ;

b) Anbringen eines leicht wieder entfernbaren Maskierungsbandes (7) auf der Oberfläche der flexiblen Schaltung (2), mit Ausnahme der Anschlußbereiche (1) der flexiblen Schaltung und der Bohrungen (6) ;

c) Stromloses Plattieren aller frei zugänglichen Oberflächen sowie der Innenwandungen der Bohrungen (6) mit einer ersten elektrisch leitenden Schicht (8) ;

d) Auftragen einer Photoresist-Schicht (9) auf die erste leitende Schicht (8) im Bereich das Maskierungsbandes (7), mit Ausnahme der Anschlußbereiche (1) der flexiblen Schaltung und der Innenwandungen der Bohrungen (6) ;

e) elektrolytisches Plattieren einer gleichmäßigen, elektrisch leitenden zweiten Schicht (10) auf die Innenwandungen der Bohrungen (6) sowie den mit der ersten leitenden Schicht (8) bedeckten Anschlußbereichen (1) ;

f) Entfernen der Photoresist-Schicht (9) mit Hilfe einer Lösungsflüssigkeit ;

g) Abziehen des Maskierungsbandes (7) mit dem darauf befindlichen Abschnitt der Plattierungsschicht (8).

2. Verfahren nach Anspruch 1, dadurch gekennzeichnet, daß das Maskierungsband (7) aus einer selbstklebenden PVC-Folie besteht.

3. Verfahren nach Anspruch 1 oder 2, dadurch gekennzeichnet, daß die erste leitende Schicht (8) chemisch abgeschieden wird und aus Kupfer besteht.

**Claims**

1. Process for producing plated through-holes (6) in a composite structure consisting of a flexible (2) and a rigid (4) printed circuit, which process comprises the following process steps :

a) production of through-holes (6) within the respective connection regions (1, 3) of the flexible (2) and the rigid (4) printed conductor board ;

b) application of a masking tape (7), which can easily be removed again, to the surface of the flexible circuit (2), with the exception of the connection regions (1) of the flexible circuit and of the holes (6) ;

c) electroless plating of all the freely accessible surfaces and of the inside walls of the holes (6) with a first electrically conducting layer (8) ;

d) deposition of a photoresist layer (9) on the first conducting layer (8) in the region of the masking tape (7), with the exception of the connection regions (1) of the flexible circuit and of the inside walls of the holes (6) ;

e) electrolytic plating of a uniform electrically conducting second layer (10) onto the inside walls of the holes (6) and also the connecting regions (1) covered with the first conducting layer (8) ;

f) removal of the photoresist layer (9) by means of a dissolving liquid ;

g) peeling-off of the masking tape (7) with the section of the plating layer (8) situated thereon.

2. Process according to Claim 1, characterized in that the masking tape (7) consists of a self-adhesive PVC film.

3. Process according to Claim 1 or 2, characterized in that the first conducting layer (8) is deposited chemically and consists of copper.

**Revendications**

1. Procédé de fabrication de circuits imprimés à trous métallisés (6) dans un assemblage constitué d'un circuit imprimé flexible (2) et d'un circuit imprimé rigide (4), qui comprend la combinaison des étapes de fabrication suivantes :

a) Réalisation de trous de part en part (6) dans chaque zone de raccordement (1 et 3) de la plaque à circuit imprimé flexible (2) et de la plaque à circuit imprimé rigide (4) ;

b) Application d'une bande de masquage (7) pouvant être facilement éliminée sur la surface du circuit flexible (2), à l'exception de la zone de raccordement (1) du circuit flexible et des trous (6) ;

c) Métallisation sans courant de toutes les surfaces librement accessibles, ainsi que des parois intérieures des trous (6) au moyen d'une première couche (8) électriquement conductrice ;

d) Application d'une couche photorésistante (9) sur la première couche conductrice (8) dans la zone de la bande de masquage (7), à l'exception de la zone de raccordement du circuit flexible (1) et des parois intérieures des trous (6) ;

e) Métallisation électrolytique avec application d'une seconde couche (10) uniforme et électriquement conductrice sur les parois intérieures des trous (6), ainsi que sur la zone de raccordement (1) recouverte par la première couche conductrice (8) ;

f) Elimination de la couche photorésistante (9) à l'aide d'un liquide dissolvant ;

g) Enlèvement de la bande de masquage (7) avec la section de la couche de métallisation (8) qui s'y trouve.

2. Procédé selon la revendication 1, caractérisé en ce que la bande de masquage (7) est constituée d'une feuille de PVC autocollante.

3. Procédé selon la revendication 1 ou 2, caractérisé en ce que la première couche conductrice (8) est déposée chimiquement et est constituée de cuivre.

# FIG. 1

# FIG. 2

# FIG. 3

# FIG. 4

# FIG. 5

# FIG. 6

# FIG. 7